# EUROPEAN PATENT SPECIFICATION

(11) **EP 4 035 506 B1**
(45) Date of publication and mention of the grant of the patent: **30.04.2025**
(21) Application number: 20775339.3
(22) Date of filing: 25.09.2020
(51) Int. Cl.: H05H 1/24, H05H 1/48, H01J 37/32, B23Q 1/44, B23Q 1/70

(54) **A PLASMA DEVICE AND A METHOD FOR GENERATING A PLASMA**
PLASMAVORRICHTUNG UND VERFAHREN ZUR ERZEUGUNG EINES PLASMAS
DISPOSITIF À PLASMA ET PROCÉDÉ DE GÉNÉRATION D'UN PLASMA

(30) Priority: 27.09.2019 LU 101420
(43) Date of publication of application: 03.08.2022
(73) Proprietor: Univerza V Ljubljani, 1000 Ljubljana (SI); Institute Jozef Stefan, 1000 Ljubljana (SI); Certottica Scrl, 32013 Longarone (BL) (IT)
(72) Inventor: DAHLE, Sebastian, 38678 Clausthal-Zellerfeld (DE); ZIGON, Jure, 1000 Ljubljana (SI); PETRIC, Marko, 1000 Ljubljana (SI); KOVAC, Janez, 1000 Ljubljana (SI); DA CORTÀ, Giuseppe, 32044 Pieve di Cadore (BL) (IT)
(74) Representative: Zacco GmbH
(86) International application number: PCT/EP2020/076861
(87) International publication number: WO 2021/058720

(56) References cited:
- WO-A2-2009/142400
- DE-A1- 102014 105 233
- US-A- 4 306 175
- US-A1- 2013 306 100

## Description

The invention concerns a plasma device and a method for generating a plasma.

Plasma treatments of surfaces are used in a multitude of industrial fields. Non-thermal plasmas provide means for surface modification, functionalization, and coating. Non-thermal plasmas can be utilized on all material classes, including metals, glass, ceramics, polymers, and bio-based materials. At atmospheric pressure, the most typical non-thermal plasmas are Corona plasma and dielectric barrier discharge (DBD) plasma.

The DBD plasma is more broadly utilized than Corona plasma since it exhibits better scalability, ease of implementation, and the widest range of applications. Corona plasma is extending from sharp tips or edges, and thus provides limited homogeneity and scaling capabilities for larger areas. However, there are certain limitations to the application of DBD plasmas as well: The distance of the two electrodes, in between which the plasma is ignited, can only be increased up to a few centimetres, as the required voltages otherwise exceed commonly available and manageable high voltage power supplies. Further, the gap width is an important factor to be precisely maintained in order to ensure the desired reproducibility of the plasma treatments' effects.

The state of the art presents several ways to circumvent, albeit in part, the aforementioned limitations. By casting all electrodes into a single plate in specific arrangements, the plasma can be ignited on the plate's surface. These surface discharges can then be brought close to work pieces, which are then treated. Such arrangements can yield indirect treatments by diffusion of reactive species onto the work pieces' surfaces or direct treatments, in many cases by the discharge gliding over onto the work pieces' surfaces. Both implementations require very low distances between electrode and substrate, which are even harder to maintain then for a conventional DBD.

In medical applications, wounds and skin are treated such that the treated areas act as one of the electrodes. This is possible to transfer to technical applications on metal work pieces, but only in some special cases possible for isolators such as polymers, ceramics, glass, or bio-based materials.

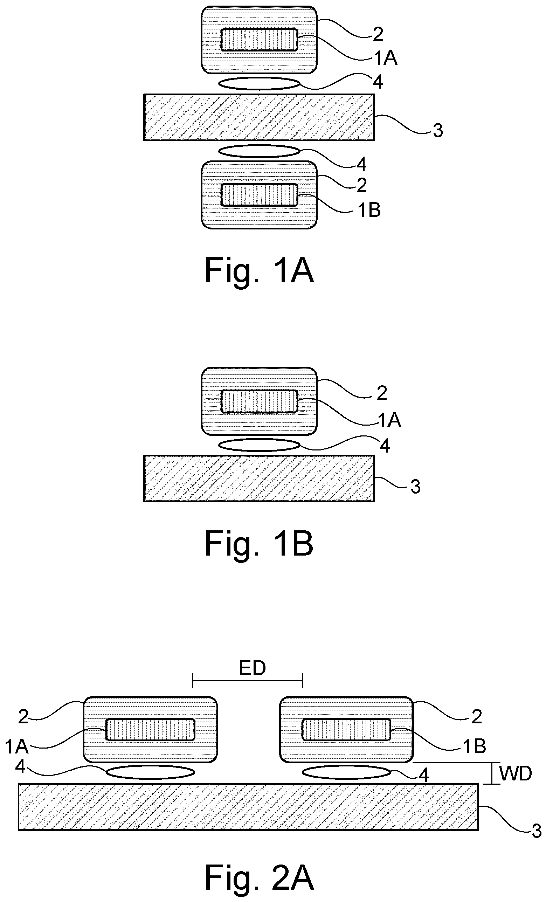

Figs. 1A and 1B illustrate two most common examples of conventional DBD arrangements for surface treatments. In Fig. 1A two high voltage (HV) electrodes 1A and 1B of opposite polarities are each covered by a dielectric material 2 and are positioned at two opposing sides of a non-conductive work piece 3, which may be, for example, a polymer sheet or foil or a wooden plank or plate. A plasma discharge 4 is generated in the gaps between the electrodes 1A, 1B and the work piece 3. The treatment of a metallic work piece 3 is more commonly done by utilizing the work piece 3 itself as the grounded electrode in front of a dielectrically covered HV electrode 1A as shown in Figure 1B.

Figs. 2A to 2D illustrate four approaches to arrange for surface treatments of non-conductive substrates independently of their geometrical dimensions, whereas the arrangement in Fig. 1A is dependent on and largely limited especially by the work piece's thickness. In contrast to that, the direct DBD treatment can be arranged in certain cases by using the dielectric properties of the work piece to forward the electric fields, thus putting it on a floating potential influenced by both HV electrodes 1A, 1B.

As shown in Fig. 2A, this floating-electrode DBD (FE-DBD) approach allows positioning both HV electrodes 1A, 1B on the same side of the work piece 3, thus making it mostly independent of the thickness of the work piece 3. In Fig. 2A ED is the electrode distance between the two electrodes 1A, 1B and WD denotes the working distance between the dielectric material 2 covering the electrodes 1A, 1B and the work piece 3.

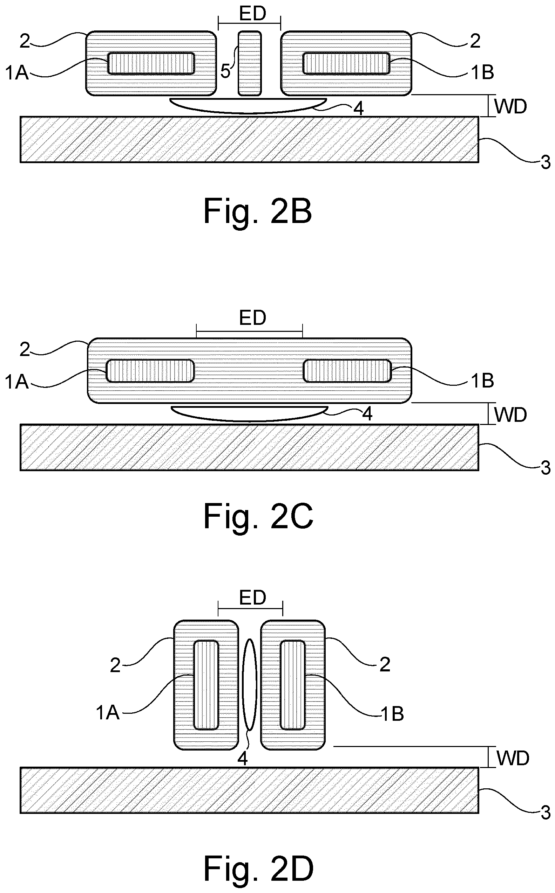

Fig. 2B depicts an arrangement denoted as gliding discharge that is applicable in cases where the FE-DBD would not work. The plasma discharge 4 ignites in between the electrodes 1A, 1B, but is passing over an insulating part 5 of the setup. Thus, the plasma discharge 4 is extended outwards in the direction of the work piece 3, onto the surface of which it may further extend.

Fig. 2C illustrates a so-called surface discharge, where both electrodes 1A, 1B of opposite polarities are cast into a single matrix of the dielectric material 2. Their position near the surface of the matrix allows the electric field to extend out and ignite a plasma discharge 4 just on the surface of the matrix. Further variations of this setup position one grounded electrode on top of the matrix, or both electrodes on opposing sides of a dielectric sheet material. Essentially, the functionality is the same for all such variations.

In Figure 2D the so-called remote plasma is shown, resembling a fourth approach to be independent of the work piece's dimension. This approach is also called a plasma jet, as the excitation of the plasma discharge 4 occurs inside of the tool, whereas the reactive plasma gas is blown out of the device through an opening or a nozzle at the base of the tool. For this setup, only long-lived reactive species can reach the surface of the work piece 3, whereas many possible reactions induced by direct plasma treatments are excluded. Further, the distance to the work piece 3 is critical to the reproducibility of the desired outcomes. Furthermore the disadvantages of all plasma jets are their highly localized treatment as limited by the nozzle size as well as their high demand of gas throughput, where most typical high-purity argon is used as working gas.

All the approaches discussed above present limitations regarding their applicability. In all cases, the arrangement of the electrodes needs to be stable and precisely defined to ensure reproducible results of the treatments. In the cases of FE-DBD, gliding discharge, and surface discharge as shown in Figs. 2A to 2C, the working distances WD shall be even smaller than for the conventional treatments shown in Figs. 1A and 1B, typically around or below 1 mm. This can be very difficult to control especially for large area treatments, large work pieces in general, and in industrial environments. For the remote plasma, working distances WD are usually much larger, especially in those cases where an arc or other thermal plasmas are used. Therefore, even the case presented in Fig. 2D requires an elaborate positioning system to be precise and timely.

Further conventional plasma devices are disclosed in WO 2009/142400 A2, US 2013/306100 A1, US 4 306 175 A1 and DE 10 2014 105233 A1.

It is an underlying object of the invention to provide a plasma device that self-adapts to variations between work pieces. In particular, the plasma device shall ensure the correct working distance. It is further an object of the invention to provide a method for generating a plasma by means of the plasma device.

The object underlying the invention is satisfied by the features of the independent claims. Advantageous further developments and aspects of the invention are set forth in the dependent claims.

In a first aspect of the instant application a plasma device is provided. The device comprises a mounting support, at least one first lever, at least one second lever and a first electrode. The plasma device is however not limited to these components and can include other components, for example, additional levers and/or electrodes, as described further below.

The mounting support may be positioned on a stable work surface and, optionally, may be firmly connected to this surface. The mounting support may also be denoted as frame, fixture, bracket or holder. The at least one first lever is rotatably mounted on the mounting support so that the at least one first lever can pivot around a fulcrum at the mounting support. Further, the at least one second lever is rotatably mounted on the at least one first lever thus enabling the at least one second lever to pivot with respect to the at least one first lever. The first electrode is attached to the at least one second lever.

The plasma is generated by means of the first electrode and, if needed, further electrodes. A work piece that is to be treated by the plasma may be moved with respect to the mounting support such that the first electrode glides over a surface of the work piece. The combination of the first and second levers achieves the self-adaptation of the system to variations between different work pieces.

The plasma device provides a mechanically adaptive system that automatically ensures and maintains correct gap distance. It stands out in that it does not require regulating units, elaborate electronic controls, or extensive adaptions for changing sizes of work pieces. The plasma device allows for a simpler and more reliable application of all types of plasmas and, in particular, DBD plasmas, such as direct, gliding, floating electrode, surface, remote DBD, and jet plasma. The plasma generated by the plasma device can be applied on all material classes including metals, alloys, oxides, ceramics, glasses, polymers, or bio-based materials such as wood or paper, and various composites thereof.

Areas of application for the plasma device can be industrial and personal equipment for cleaning or pre-treatment of surfaces in various applications such as coating, gluing, forming composites and many more.

At least one first spacer is movably mounted on the first electrode and is configured to provide a predetermined distance of the first electrode from a work piece. The at least one first spacer ensures the correct working distance between the first electrode and the surface of the work piece while the first electrode glides over this surface.

Including positioning items such as the first spacer to ensure the correct working distance does not appear intuitive to the typical designer of such plasma devices, as the plasma treatment is becoming heterogeneous. The desired uses in many fields of applications, such as enhanced wetting, coating, or gluing, are happening on larger scales, so that this small inhomogeneity is negligible for the desired outcome. In other cases of application, the inhomogeneity can be overcome by combining two or more such electrodes within one system.

As explained above, metallic work pieces require only one electrode as the metallic work piece can be utilized as a grounded electrode by electrically connecting the work piece to ground potential. For all other materials at least two electrodes are required. In one embodiment, the plasma device comprises a second electrode attached to the at least one second lever. Since both the first and the second electrodes are attached to the at least one second lever, the distance between the first and second electrodes is fixed.

Similar to the at least one first spacer, at least one second spacer may be provided that is movably mounted on the second electrode and configured to provide a predetermined distance of the second electrode from the work piece while the second electrode glides over the work piece. The at least one second spacer may comprise the embodiments disclosed in this application in connection with the at least one first spacer.

In case a third electrode is necessary, the chain of the first and second levers may be extended by adding at least one third lever that is rotatably mounted on the at least one second lever. The third electrode is attached to the at least one third lever. Similar to the first and second electrodes, the third electrode may be equipped with at least one third spacer that is movably mounted on the third electrode and configured to provide a predetermined distance of the third electrode from the work piece. The at least one third spacer may comprise the embodiments disclosed in this application in connection with the at least one first spacer.

In the way as described above, the chain of consecutive levers can be easily extended by adding another lever to the end of the chain for each additional electrode. The system is scalable and can host a chain of as many electrodes as the application may require.

In addition to that, the lever system can be used to host probes and measurement tools, in particular diagnostic tools, including for example fiber-based ultraviolet or infrared spectroscopy, color and gloss measurement tools as well as dielectric and capacity probes. Some of these probes are strongly dependent on precise control of the distance to the surface, the angle with the surface normal, and other geometrical factors. Therefore, at least one fourth lever can be rotatably mounted on one of the at least one first, second and third levers, wherein the probe and/or the measurement tool are attached to the at least one fourth lever. This includes the opportunity to arrange the probe and/or the measurement tool both, before and after the plasma processing, by simply adding the at least one fourth lever at the desired position in the lever chain, for example, between the first and second levers or after the second or third lever.

Furthermore, one or more appropriate spacers may be, in particular movably, mounted on the probe and/or the measurement tool in order to ensure a predetermined distance of the probe and/or the measurement tool from the work piece.

In the following features of the first electrode regarding the shape of the electrode, a tube covering the electrode and spacers mounted on the tube are described. These features can also be applied to other electrodes described herein, for example, the second and third electrodes, as well as the probe and the measurement tools that can be mounted on the at least one fourth lever.

The outer surface of the first electrode may have a round cross-section. The first electrode may have at least partially the shape of a cylinder. Such a shape of the first electrode facilitates the gliding movement of the first electrode over a surface of the work piece.

A tube made of a dielectric material that is electrically insulating may cover the first electrode. The dielectric tube may effectively prevent arcing. The dielectric material may consists of or contain Teflon (polytetrafluoroethylene, PTFE), ceramics, in particular alumina (Al₂O₃), epoxy polymers, in particular the glass fibre reinforced polymer FR4, or any other appropriate material.

In one embodiment, the at least one first spacer is at least one ring that is movably mounted on the tube such that the at least one ring can glide on the tube when the first electrode is moved over the work piece. There may be several rings mounted on the first electrode with a certain distance between neighboring rings. The rings may be made of a dielectric material, for example, Teflon or any of the materials mentioned above in connection with the tube covering the first electrode. Teflon material provides sufficiently low friction for turning rings to glide on the tube, which may be also made of Teflon. The rings may be sized such that the wall thickness resembles the desired working distance, whereas the inner diameter of the rings may be sufficiently larger than the tube diameter to ensure an easy rotation. The rings may be kept in place on the tube through notches or rib profiles at the outer surface of the tube or a guiding element as described below. The width of the rings in the direction of the main axis of the tube can be small in relation to their thickness and diameter.

In addition, at least one guiding element may be attached to the at least one second lever. The at least one guiding element may be configured to guide the at least one ring. In particular, the at least one guiding element may guide the at least one ring with respect to the main axis of the tube, i.e., in a direction perpendicular to the movement of the work piece. The at least one guiding element may be at least one side stop limiting the movement of the at least one ring along the tube. A connecting element may be attached to the second lever holding the at least one guiding element. The at least one guiding element may be made of rubber or any other suitable material, for example, plexiglass.

In an alternative embodiment, the tube is movably mounted on the first electrode and the first spacers are embodied as one or more ribs protruding from the surface of the tube. Further, the ribs may be either firmly attached to the tube or may be a part of the tube. A gap between the first electrode and the tube may be dimensioned sufficiently large such that the tube can rotate with respect to the first electrode when the first electrode glides over the surface of the work piece. In this embodiment, the tube acts as a roller that includes spacers in the form of the ribs which ensure the desired working distance.

The at least one first lever may consist of a pair of first levers and the at least one second lever may consist of a pair of second levers. In the same way, the other levers may each consist of a pair of levers. The two levers of each pair may be identical or may have identical dimensions. Each of the electrodes, probes and/or measurement tools may be arranged at least partially between the two levers of the respective pair.

The plasma device may further comprises a driving unit to move the work piece with respect to the mounting support. The driving unit can be configured to move the work piece such that it passes below the one or more electrodes in order to treat the work piece by the plasma generated by the electrodes.

The mounting support may be configured such that the position of a pivot point of the first lever, in particular the height of the pivot point, is variable or adjustable. The mounting support thus allows to optimize the position of the fulcrum or pivot point, around which the first lever rotates.

In addition or alternatively, the length of the first lever may be variable or adjustable. The height of the pivot point at the mounting support together with the length of the first lever are parameters to ensure smooth operation of the plasma device, and might be optimized according to the expected range of the dimensions of the work piece.

According to a second aspect of the application, a method for generating a plasma by means of the plasma device described above comprises that at least the first electrode generates a plasma, and the first electrode glides over a surface of a work piece while the work piece is moved with respect to the mounting support.

The method may comprise the embodiments disclosed above in connection with the plasma device according to the first aspect of the application.

The following description of figures may further illustrate and explain exemplary embodiments. Components that are functionally identical or have an identical effect are denoted by identical reference numerals. Identical or effectively identical components might be described only with respect to the figures where they occur first. Their description is not necessarily repeated in successive figures. There are shown in the drawings:
- Figs. 1A to 1B: schematic representations of examples of conventional DBD arrangements for surface treatments;
- Figs. 2B to 2D: schematic representations of DBD arrangements for surface treatments of non-conductive substrates independently of their geometrical dimensions;
- Figs. 3A to 3C: schematic representations of an exemplary embodiment of a plasma device from various perspectives;
- Figs. 4A to 4C: schematic representations of an exemplary embodiment of an electrode with a tube and movably attached rings from various perspectives;
- Figs. 5A to 5C: schematic representations of an exemplary embodiment of an electrode with a movably attached tube including ribs from various perspectives;
- Figs. 6A to 6B: schematic representations of a further exemplary embodiment of a plasma device from various perspectives;
- Figs. 7A to 7B: schematic representations of yet a further exemplary embodiment of a plasma device from various perspectives; and
- Figs. 8A to 8E: schematic representations of yet a further exemplary embodiment of a plasma device from various perspectives.

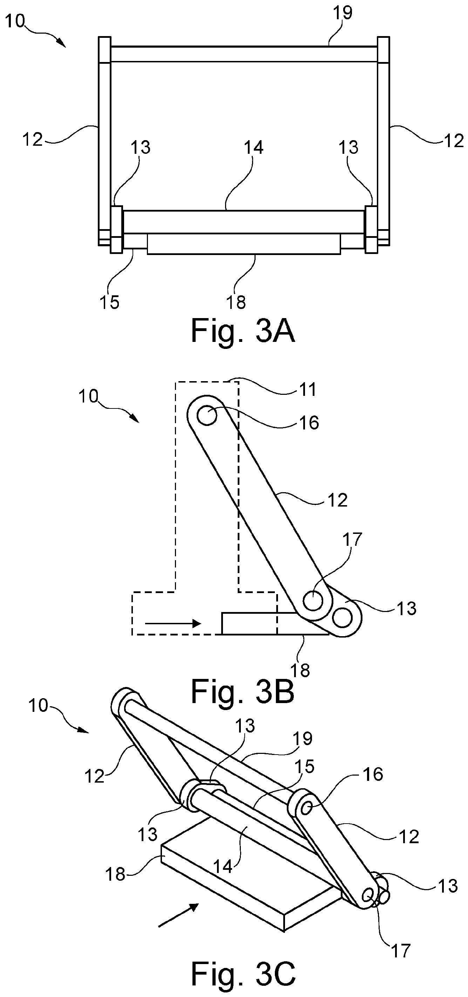

Figs. 3A to 3C of the drawings illustrate schematic representations of a plasma device 10, which is an exemplary embodiment of the plasma device according to the first aspect of the application. In the following the plasma device 10 will be described and also the functioning of the plasma device 10, which is an exemplary embodiment of the method for generating a plasma according to the second aspect of the application.

Figs. 3A, 3B and 3C show a front view, a side view and a three dimensional view of the plasma device 10, respectively.

The plasma device 10 includes a mounting support 11, which is only depicted in Fig. 3B by dashed lines. The mounting support 11 may be positioned on a stable work surface. In addition, the plasma device 10 includes a pair of first levers 12, a pair of second levers 13, a first electrode 14 and a second electrode 15.

The first levers 12 are identical to each other, and the second levers 13 are identical to each other. The first levers 12 are longer than the second levers 13. The first levers 12 are attached to the mounting support 10 at one of their ends. At the other ends the first levers 12 are attached to a respective one of the second levers 13. The first levers 12 are attached to the mounting support 10 such that they can rotate or pivot about an attachment or pivot point 16. The second levers 13 are attached to the first levers 12 such that they can rotate or pivot about an attachment or pivot point 17.

The first electrode 14 and the second electrode 15 are attached in between the two second levers 13. The first electrode 14 and the second electrode 15 have a cylindrical shape and are arranged in parallel. The distance between the first and second electrodes 14, 15 is the electrode distance ED.

The plasma device 10 can be extended by adding further levers to the end of the chain for each additional electrode or probe or measurement tool.

Figs. 3A to 3C show the plasma device 10 while generating plasma by the first and second electrodes 14, 15 for treating a box-shaped work piece 18. The work piece 18 is moved in a direction indicated by an arrow. Figs. 3A to 3C show a time instance in which the work piece 18 enters the double-lever system. The first electrode 14 has already moved to adapt to the surface height of the work piece 18 and the second electrode 15 is about to be moved into a position for the work piece 18 to pass through below. When the work piece 18 passes the first and second electrodes 14, 15, the top surface of the work piece 18 is treated by the plasma generated by the first and second electrodes 14, 15.

The length of the first, long levers 12 shall ideally be sized approximately by a factor 10 larger than the expected variation of the work pieces 18 due to different heights, jumpy or vibrating movements, and others. A top axle 19 holding the first levers 12 shall be mounted high enough to ensure that the system does not exceed 45 degrees under expected operational circumstances; otherwise, friction and vibration might lead for the system to jam. The second, short levers 13, which are potentially repeated, shall be sized according to the desired electrode distance and the foreseen mode of operation. In the simplest implementation, the system is positioned vertically above the work pieces 18 so that it is driven solely by gravity. However, other forms of implementations can include dampers, e.g., to account for strong vibrations, or springs and limit stops, e.g., to account for reaction times of the system and for other orientations of positioning.

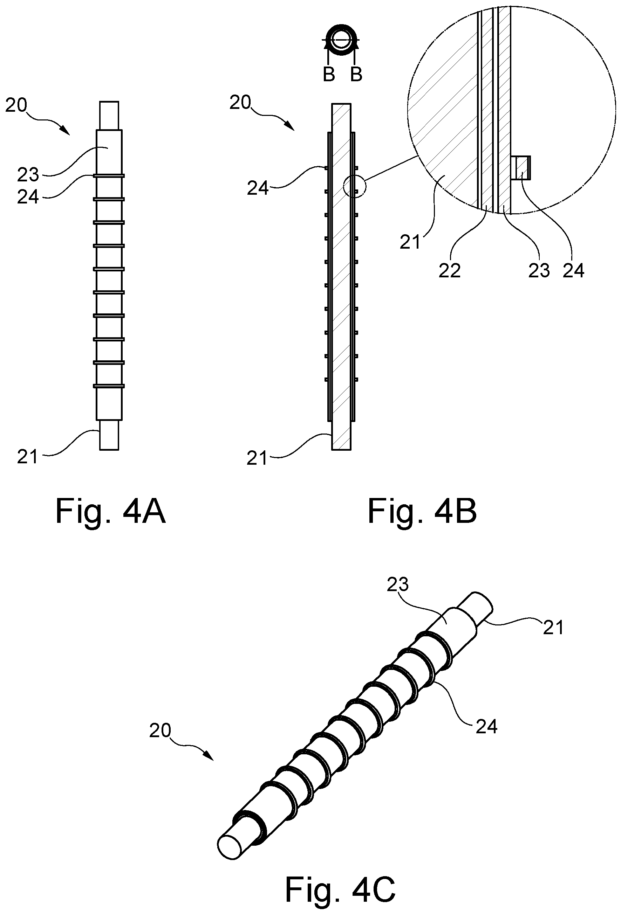

Figs. 4A to 4C illustrate schematic representations of an electrode 20, which can be utilized as the first or second electrode 14, 15 of the plasma device 10 shown in Figs. 3A to 3C.

Figs. 4A and 4B show a side view and a cross-section of the electrode 20, respectively. Fig. 4C shows a three-dimensional view of the electrode 20.

The electrode 20 includes a copper layer 22 mounted on a hollow, cylindrical axle 21, through which the electrical contact is fed. A Teflon tube 23 with a wall thickness of 1 mm covers the copper layer 22 and reaches at least 1 cm over both ends of the copper layer 22 in order to effectively prevent arcing.

Several Teflon rings 24 are movably mounted on the tube 23. The Teflon material of the tube 23 provides sufficiently low friction for turning the rings 24 to glide upon it while the electrode 20 glides over a work piece. The rings 24 are sized such that their wall thickness resembles the desired working distance, whereas the inner diameter of the rings 24 is sufficiently larger than the diameter of the tube 23 to ensure an easy rotation. This further allows for positioning multiple rings 24 over the tube 23, where they are kept in place through notches or rib profiles at the outer surface of the tube 23. The width of the rings 24 in the direction of the axle 21 can be small in relation to its thickness and diameter.

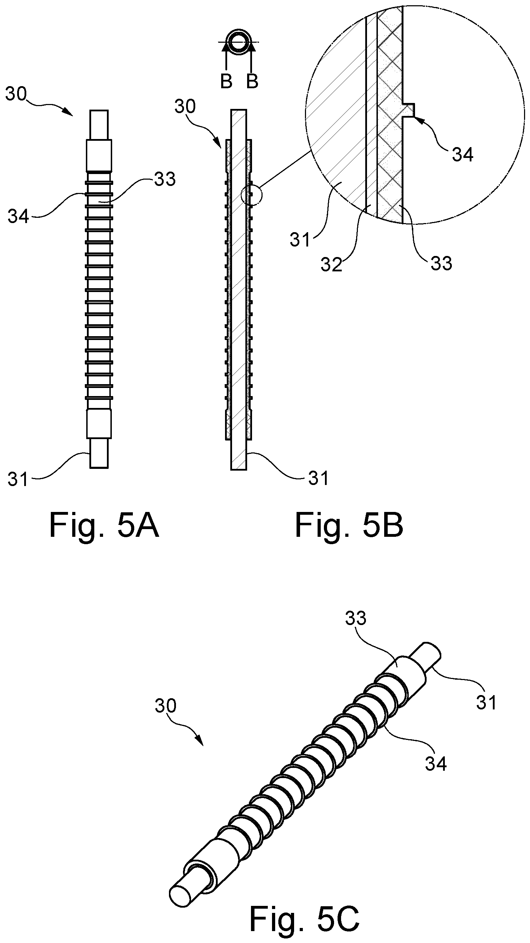

Figs. 5A to 5C illustrate schematic representations of an electrode 30 as an alternative embodiment of the first and/or second electrodes 14, 15. Similar to the electrode 20, the electrode 30 includes a copper layer 32 mounted on a hollow axle 31. In the electrode 30 a solid Teflon hose or tube 33 covers the copper layer 32. The cleavage between the tube 33 and the copper layer 32 shall be dimensioned suitably large to ensure a smooth turning movement of the tube 33. Notches are drilled into the tube 33 to make room for the plasma and creating ribs 34. This cleavage presents the working distance, which is maintained by the remaining rib structures. At the position of a notch, a minimum dielectric thickness of 1 mm shall remain. The width of the ribs 34 shall be dimensioned according to their height and the expected loads or impacts for the application case to achieve a sufficiently long operation period before maintenance, i.e., replacement of the dielectric structure. If needed, more complex shapes can be designed instead of simple ribs in order to tailor the system to specific needs of a substrates.

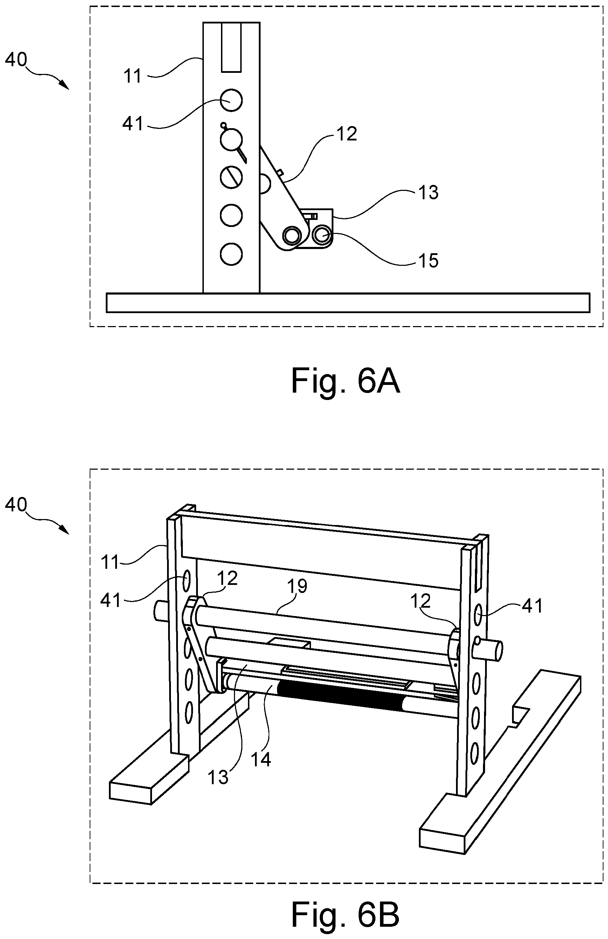

Figs. 6A and 6B show a side view and a three dimensional view of a plasma device 40, respectively. The components of the plasma device 40 are denoted by the same reference numerals as used in Figs. 3A to 3C. In the exemplary embodiment shown in Figs. 6A and 6B the mounting support 11 has several openings 41, into which the top axle 19 can be inserted to adjust the vertical position of the double-lever system. The plasma device 40 can be used, for example, for direct DBD or FE-DBD treatment of work pieces.

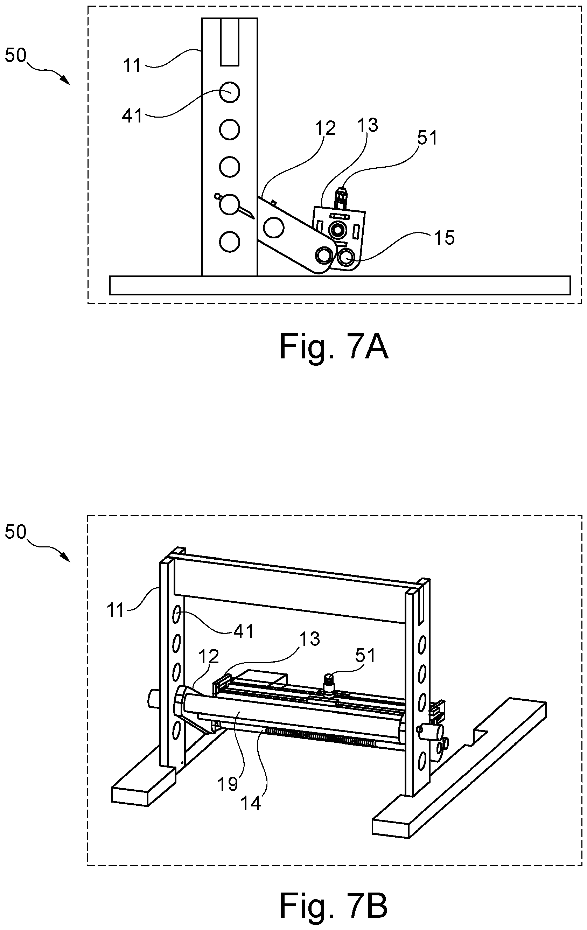

Figs. 7A and 7B show a side view and a three dimensional view of a plasma device 50, respectively. The plasma device 50 can be used for remote DBD, i.e., plasma jet, treatments of work pieces. The plasma device 50 has a connection 51 for compressed air, which can be blown between the first and second electrodes 14, 15.

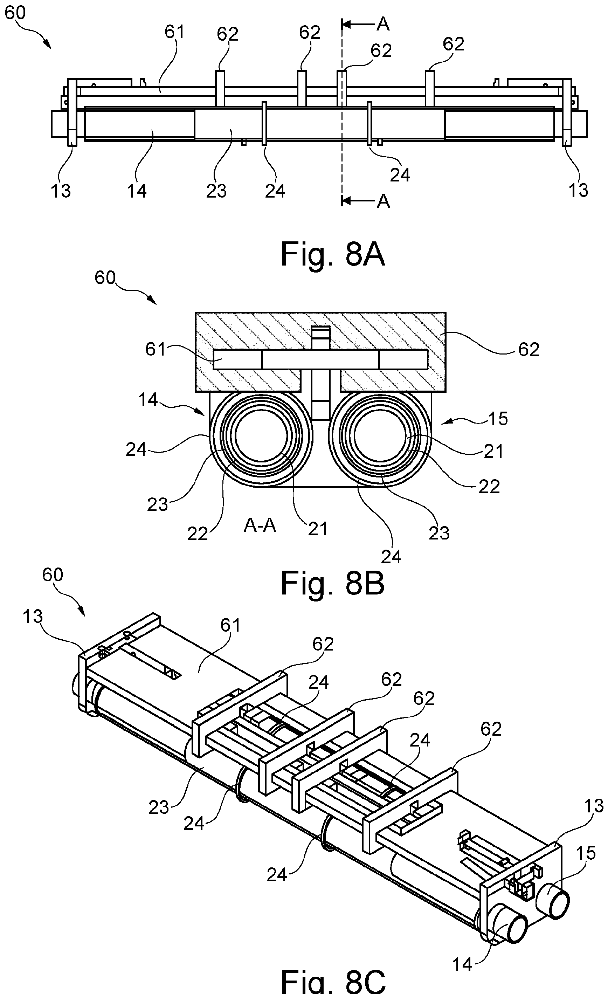

Figs. 8A to 8E shows different views of a plasma device 60, wherein, for the sake of clarity and ease of comprehension, the mounting support 11 and the first levers 12 are not shown.

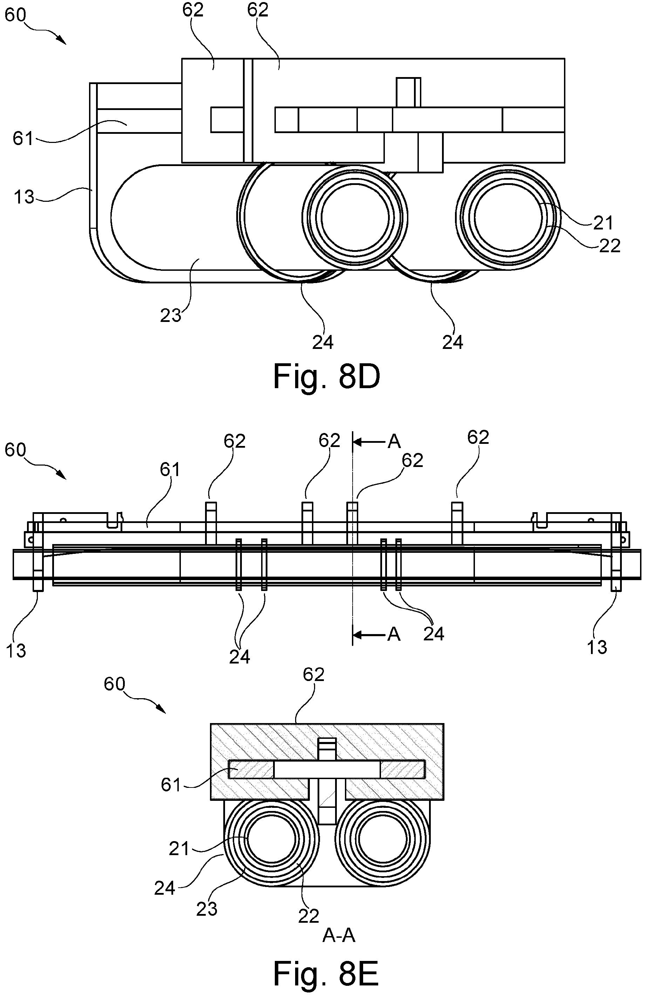

Fig. 8A shows a front view of the plasma device 60 and Fig. 8B shows a cross-section of the plasma device 60 along the line A-A depicted in Fig. 8A. Figs. 8C and 8D illustrate three dimensional views of the plasma device 60 from different perspectives. Fig. 8E shows cross sections of the plasma device 60.

The first and second electrodes 14, 15 of the plasma device 60 are embodied in the same way as the electrode 20 described above and illustrated in Figs. 4A to 4C. Thus, each of the first and second electrodes 14, 15 includes an electrically conductive layer, for example a copper layer 22, mounted on a hollow, cylindrical axle 21, and a Teflon tube 23 covering the copper layer 22. In addition, rings 24 made of Teflon are movably mounted on the tube 23.

The two second levers 13 together with a connecting element 61 form a frame made of plexiglass holding the first and second electrodes 14, 15. Due to the connecting element 61, the two second levers 13 at the sides of the frame are prevented from shearing and twisting against each other. The frame allows for enough slack that the system adapts to surfaces inclined sideways, i.e., in direction of the first and second electrodes 14, 15.

Further, guiding elements 62 are attached to the connecting element 61. The guiding elements 62 have the function of side stops for the rings 24 in order to keep them in place. The guiding elements 62 force the rings 24 to stay in a suitable position or range, so that at least two rings 24 per electrode are supporting the system upon any substrate moving through below. The guiding elements 62 can be moved along the connecting element 61 in order to adjust the range for the respective ring 24 to move along the first or second electrodes 14, 15. In practical implementations, the guiding elements 62 can be rubber rings.

The guiding elements 62 can exhibit a very low conductivity so that a small part of the plasma discharge ignites against them as well. This just slightly reduces the energy efficiency of the process, but during times without a substrate present, this small energy loss prevents damage to the power supply as otherwise without plasma ignition the electrical energy would be reflected back into the power supply.

### LIST OF REFERENCE NUMERALS

- 1A: electrode
- 1B: electrode
- 2: dielectric material
- 3: work piece
- 4: plasma discharge
- 5: insulating part
- 10: plasma device
- 11: mounting support
- 12: first lever
- 13: second lever
- 14: first electrode
- 15: second electrode
- 16: pivot point
- 17: pivot point
- 18: work piece
- 19: axle
- 20: electrode
- 21: axle
- 22: copper layer
- 23: tube
- 24: ring
- 30: electrode
- 31: axle
- 32: copper layer
- 33: tube
- 34: rib
- 40: plasma device
- 41: opening
- 50: plasma device
- 51: connection
- 60: plasma device
- 61: connecting element
- 62: guiding element

## Claims

1. A plasma device (10, 40, 50, 60) comprising:
a mounting support (11),
at least one first lever (12) rotatably mounted on the mounting support (11),
at least one second lever (13) rotatably mounted on the at least one first lever (12), and
a first electrode (14) attached to the at least one second lever (13),
wherein at least one first spacer (24,34) is movably mounted on the first electrode (14) and configured to provide a predetermined distance of the first electrode (14) from a work piece (18).

2. The plasma device (10, 40, 50, 60) as claimed in claim 1, further comprising a second electrode (15) attached to the at least one second lever (13).

3. The plasma device (10, 40, 50, 60) as claimed in claim 2, wherein at least one second spacer (24, 34) is movably mounted on the second electrode (15) and configured to provide a predetermined distance of the second electrode (15) from the work piece (18).

4. The plasma device (10, 40, 50, 60) as claimed in one of the preceding claims, further comprising at least one third lever rotatably mounted on the at least one second lever (13), wherein a third electrode is attached to the at least one third lever.

5. The plasma device (10, 40, 50, 60) as claimed in one of the preceding claims, further comprising at least one fourth lever rotatably mounted on one of the at least one first, second and third levers, wherein a probe and/or a measurement tool are attached to the at least one fourth lever.

6. The plasma device (10, 40, 50, 60) as claimed in one of the preceding claims, wherein the cross-section of the outer surface of the first electrode (14) is at least partially round.

7. The plasma device (10,40,50,60) as claimed in one of the preceding claims, wherein a tube (23,33) made of a dielectric material covers the first electrode (22).

8. The plasma device (10, 40, 50, 60) as claimed in claim 7, wherein the at least one first spacer is at least one ring (24) movably mounted on the tube (23).

9. The plasma device (60) as claimed in claim 8, wherein at least one guiding element (62) is attached to the at least one second lever (13) and is configured to guide the at least one ring (24).

10. The plasma device (10, 40, 50, 60) as claimed in claim 7, wherein the tube (33) is movably mounted on the first electrode (22) and the at least one first spacer is at least one rib (34) protruding from the surface of the tube (33).

11. The plasma device (10, 40, 50, 60) as claimed in one of the preceding claims, wherein the at least one first lever is a pair of first levers (12) and the at least one second lever is a pair of second levers (13).

12. The plasma device (10, 40, 50, 60) as claimed in one of the preceding claims, further comprising a driving unit to move the work piece (18) with respect to the mounting support (11).

13. The plasma device (10, 40, 50, 60) as claimed in one of the preceding claims, wherein the mounting support (11) is configured such that the position of a pivot point (16) of the first lever (12) is adjustable.

14. The plasma device (10, 40, 50, 60) as claimed in one of the preceding claims, wherein the length of the first lever (12) is adjustable.

15. A method for generating a plasma by means of a plasma device (10, 40, 50, 60) as claimed in one of the preceding claims, wherein:
at least the first electrode (14) generates a plasma, and the first electrode (14) glides over a surface of a work piece (18) while the work piece (18) is moved with respect to the mounting support (11).

## Patentansprüche

1. Plasmavorrichtung (10, 40, 50, 60), umfassend:
eine Montagestütze (11),
mindestens einen ersten Hebel (12), der auf der Montagestütze (11) drehbar montiert ist,
mindestens einen zweiten Hebel (13), der auf dem mindestens einen ersten Hebel (12) drehbar montiert ist, und
eine erste Elektrode (14), die an dem mindestens einen zweiten Hebel (13) befestigt ist,
wobei mindestens ein erster Abstandhalter (24, 34) auf der ersten Elektrode (14) bewegbar montiert und dazu konfiguriert ist, einen vorbestimmten Abstand der ersten Elektrode (14) von einem Werkstück (18) bereitzustellen.

2. Plasmavorrichtung (10, 40, 50, 60) nach Anspruch 1, ferner umfassend eine zweite Elektrode (15), die an dem mindestens einen zweiten Hebel (13) befestigt ist.

3. Plasmavorrichtung (10, 40, 50, 60) nach Anspruch 2, wobei mindestens ein zweiter Abstandhalter (24, 34) auf der zweiten Elektrode (15) bewegbar montiert und dazu konfiguriert ist, einen vorbestimmten Abstand der zweiten Elektrode (15) von dem Werkstück (18) bereitzustellen.

4. Plasmavorrichtung (10, 40, 50, 60) nach einem der vorhergehenden Ansprüche, ferner umfassend mindestens einen dritten Hebel, der auf dem mindestens einen zweiten Hebel (13) drehbar montiert ist, wobei eine dritte Elektrode an dem mindestens einen dritten Hebel befestigt ist.

5. Plasmavorrichtung (10, 40, 50, 60) nach einem der vorhergehenden Ansprüche, ferner umfassend mindestens einen vierten Hebel, der auf einem des mindestens einen ersten, zweiten und dritten Hebels drehbar montiert ist, wobei eine Sonde und/oder ein Messwerkzeug an dem mindestens einen vierten Hebel befestigt sind.

6. Plasmavorrichtung (10, 40, 50, 60) nach einem der vorhergehenden Ansprüche, wobei der Querschnitt der Außenfläche der ersten Elektrode (14) mindestens teilweise rund ist.

7. Plasmavorrichtung (10, 40, 50, 60) nach einem der vorhergehenden Ansprüche, wobei eine Röhre (23, 33), die aus einem dielektrischen Material hergestellt ist, die erste Elektrode (22) abdeckt.

8. Plasmavorrichtung (10, 40, 50, 60) nach Anspruch 7, wobei der mindestens eine erste Abstandhalter mindestens ein Ring (24) ist, der auf der Röhre (23) bewegbar montiert ist.

9. Plasmavorrichtung (60) nach Anspruch 8, wobei mindestens ein Führungselement (62) an dem mindestens einen zweiten Hebel (13) befestigt ist und dazu konfiguriert ist, den mindestens einen Ring (24) zu führen.

10. Plasmavorrichtung (10, 40, 50, 60) nach Anspruch 7, wobei die Röhre (33) auf der ersten Elektrode (22) bewegbar montiert ist und der mindestens eine erste Abstandhalter mindestens eine Lamelle (34) ist, die von der Oberfläche der Röhre (33) hervorspringt.

11. Plasmavorrichtung (10, 40, 50, 60) nach einem der vorhergehenden Ansprüche, wobei der mindestens eine erste Hebel ein Paar erster Hebel (12) ist und der mindestens eine zweite Hebel ein Paar zweiter Hebel (13) ist.

12. Plasmavorrichtung (10, 40, 50, 60) nach einem der vorhergehenden Ansprüche, ferner umfassend eine Antriebseinheit, um das Werkstück (18) in Bezug auf die Montagestütze (11) zu bewegen.

13. Plasmavorrichtung (10, 40, 50, 60) nach einem der vorhergehenden Ansprüche, wobei die Montagestütze (11) derart konfiguriert ist, dass die Position eines Schwenkpunkts (16) des ersten Hebels (12) einstellbar ist.

14. Plasmavorrichtung (10, 40, 50, 60) nach einem der vorhergehenden Ansprüche, wobei die Länge des ersten Hebels (12) einstellbar ist.

15. Verfahren zum Erzeugen eines Plasmas mittels einer Plasmavorrichtung (10, 40, 50, 60) nach einem der vorhergehenden Ansprüche, wobei:
mindestens die erste Elektrode (14) ein Plasma erzeugt und die erste Elektrode (14) über eine Oberfläche eines Werkstücks (18) gleitet, während das Werkstück (18) in Bezug auf die Montagestütze (11) bewegt wird.

## Revendications

1. Dispositif à plasma (10, 40, 50, 60) comprenant :
un support de montage (11),
au moins un premier levier (12) monté de manière rotative sur le support de montage (11),
au moins un deuxième levier (13) monté de manière rotative sur l'au moins un premier levier (12), et
une première électrode (14) fixée à l'au moins un deuxième levier (13),
dans lequel au moins une première entretoise (24, 34) est montée de manière mobile sur la première électrode (14) et configurée pour fournir une distance prédéterminée de la première électrode (14) à partir d'une pièce à usiner (18).

2. Dispositif à plasma (10, 40, 50, 60) selon la revendication 1, comprenant en outre une deuxième électrode (15) fixée à l'au moins un deuxième levier (13).

3. Dispositif à plasma (10, 40, 50, 60) selon la revendication 2, dans lequel au moins une deuxième entretoise (24, 34) est montée de manière mobile sur la deuxième électrode (15) et configurée pour fournir une distance prédéterminée de la deuxième électrode (15) à partir de la pièce à usiner (18).

4. Dispositif à plasma (10, 40, 50, 60) selon l'une quelconque des revendications précédentes, comprenant en outre au moins un troisième levier monté de manière rotative sur l'au moins un deuxième levier (13), dans lequel une troisième électrode est fixée à l'au moins un troisième levier.

5. Dispositif à plasma (10, 40, 50, 60) selon l'une quelconque des revendications précédentes, comprenant en outre au moins un quatrième levier monté de manière rotative sur l'un parmi l'au moins un premier levier, l'au moins un deuxième levier et l'au moins un troisième levier, dans lequel une sonde et/ou un outil de mesure sont fixés à l'au moins un quatrième levier.

6. Dispositif à plasma (10, 40, 50, 60) selon l'une quelconque des revendications précédentes, dans lequel la section transversale de la surface extérieure de la première électrode (14) est au moins partiellement ronde.

7. Dispositif à plasma (10, 40, 50, 60) selon l'une quelconque des revendications précédentes, dans lequel un tube (23, 33) en matériau diélectrique recouvre la première électrode (22).

8. Dispositif à plasma (10, 40, 50, 60) selon la revendication 7, dans lequel l'au moins une première entretoise est au moins une bague (24) montée de manière mobile sur le tube (23).

9. Dispositif à plasma (60) selon la revendication 8, dans lequel au moins un élément de guidage (62) est fixé à l'au moins un deuxième levier (13) et est configuré pour guider l'au moins une bague (24).

10. Dispositif à plasma (10, 40, 50, 60) selon la revendication 7, dans lequel le tube (33) est monté de manière mobile sur la première électrode (22) et l'au moins une première entretoise est au moins une nervure (34) faisant saillie de la surface du tube (33).

11. Dispositif à plasma (10, 40, 50, 60) selon l'une quelconque des revendications précédentes, dans lequel l'au moins un premier levier est une paire de premiers leviers (12) et l'au moins un deuxième levier est une paire de deuxièmes leviers (13).

12. Dispositif à plasma (10, 40, 50, 60) selon l'une quelconque des revendications précédentes, comprenant en outre une unité d'entraînement pour déplacer la pièce à usiner (18) par rapport au support de montage (11).

13. Dispositif à plasma (10, 40, 50, 60) selon l'une quelconque des revendications précédentes, dans lequel le support de montage (11) est configuré de telle sorte que la position d'un point de pivot (16) du premier levier (12) est réglable.

14. Dispositif à plasma (10, 40, 50, 60) selon l'une quelconque des revendications précédentes, dans lequel la longueur du premier levier (12) est réglable.

15. Procédé de génération de plasma au moyen d'un dispositif à plasma (10, 40, 50, 60) selon l'une quelconque des revendications précédentes, dans lequel :
au moins la première électrode (14) génère un plasma, et la première électrode (14) glisse sur une surface d'une pièce à usiner (18) tandis que la pièce à usiner (18) est déplacée par rapport au support de montage (11).
